# FASCICULE DE BREVET EUROPEEN

(11) **EP 1 248 366 B1**
(45) Date de publication et mention de la délivrance du brevet: **06.09.2006**
(21) Numéro de dépôt: 02354052.9
(22) Date de dépôt: 02.04.2002
(51) Int. Cl.: H03H 9/24, H03H 3/00

(54) **Résonateur électromécanique à poutre vibrante**
Elektromechanischer Schwingbalkenresonator
Electromechanical resonator comprising a vibrating beam

(30) Priorité: 03.04.2001 FR 0104510
(43) Date de publication de la demande: 09.10.2002
(73) Titulaire: STMicroelectronics S.A., 92120 Montrouge (FR)
(72) Inventeur: Skotnicki, Thomas, 38920 Crolles (FR); Dutartre, Didier, 38240 Meylan (FR); Ribot, Pascal, 38190 Froges (FR)
(74) Mandataire: de Beaumont, Michel

(56) Documents cités:
- WO-A-00/42705

## Description

La présente invention concerne un résonateur électromécanique particulièrement adapté à des applications dans le domaine des radiofréquences, par exemple dans le domaine des téléphones portables.

La présente invention vise plus particulièrement un procédé de fabrication d'un tel résonateur électromécanique qui soit compatible avec la fabrication d'un circuit intégré, par exemple un circuit intégré de type MOS.

On connaît de nombreux types de résonateurs électromécaniques fabriqués avec des technologies proches de celles des circuits intégrés qui comprennent une poutre en suspension reliée à un premier potentiel, sous laquelle circule une ligne conductrice à un deuxième potentiel, de sorte que, quand la fréquence électrique est proche de la fréquence mécanique de vibration de la poutre, une résonance se produit.

On connaît par le document WO 00 42705 A un résonateur électromécanique comprenant une zone de silicium polycristallin dopée et une poutre comprenant une couche de silicium polycristallin.

Il est particulièrement important quand on vise à réaliser de tels systèmes que la fréquence de résonance soit parfaitement bien déterminée. Cette fréquence dépend notamment de l'épaisseur de la poutre, de sa longueur et des caractéristiques mécaniques du matériau dont est fabriquée la poutre. La sensibilité dépend en particulier de la distance entre la poutre et la ligne d'excitation.

La présente invention vise à prévoir une telle poutre qui soit de fabrication simple et compatible avec des technologies de circuit intégré, et qui présente une fréquence de résonance bien déterminée et stable au cours du temps.

Un autre objet de la présente invention est de prévoir un tel résonateur qui puisse être fabriqué de façon particulièrement miniaturisée, pour pouvoir atteindre des fréquences de résonance très élevées pouvant dépasser le GHz.

On notera que certaines de ces caractéristiques, et notamment les caractéristiques de stabilité et de reproductibilité des constantes mécaniques, excluent l'utilisation de silicium polycristallin comme élément essentiel de constitution de la poutre vibrante.

Pour atteindre ces objets, la présente invention prévoit un résonateur électromécanique formé sur une zone active de silicium monocristallin fortement dopée d'un substrat, constituant une première électrode délimitée par une zone isolante, comprenant une couche de silicium monocristallin reposant sur la zone isolante par au moins une de ses extrémités et espacée de la zone active.

La présente invention prévoit un procédé de fabrication d'un résonateur comprenant les étapes suivantes :
définir une zone active de silicium monocristallin délimitée par une couche d'isolant enterré ;
déposer une couche de silicium-germanium par un procédé d'épitaxie sélective de sorte que la couche de silicium-germanium croisse au-dessus de la zone active de silicium monocristallin et légèrement au-delà de la périphérie de cette zone active ;
déposer par un procédé d'épitaxie non-sélective une couche de silicium et la graver selon un contour désiré ; et
éliminer le silicium-germanium par une gravure sélective par rapport au silicium et à l'isolant.

Selon un mode de réalisation de la présente invention, le procédé comprend en outre, après la gravure du silicium-germanium, une étape d'oxydation.

Selon un mode de réalisation de la présente invention, le procédé comprend une étape de formation de contacts.

Selon un mode de réalisation de la présente invention, la gravure chimique sélective du silicium-germanium est assistée par plasma.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 sont des vues en coupe schématiques illustrant des étapes successives d'un procédé de fabrication selon la présente invention ; et
la figure 3 est une vue en perspective schématique illustrant une étape ultérieure de fabrication d'un résonateur selon la présente invention.

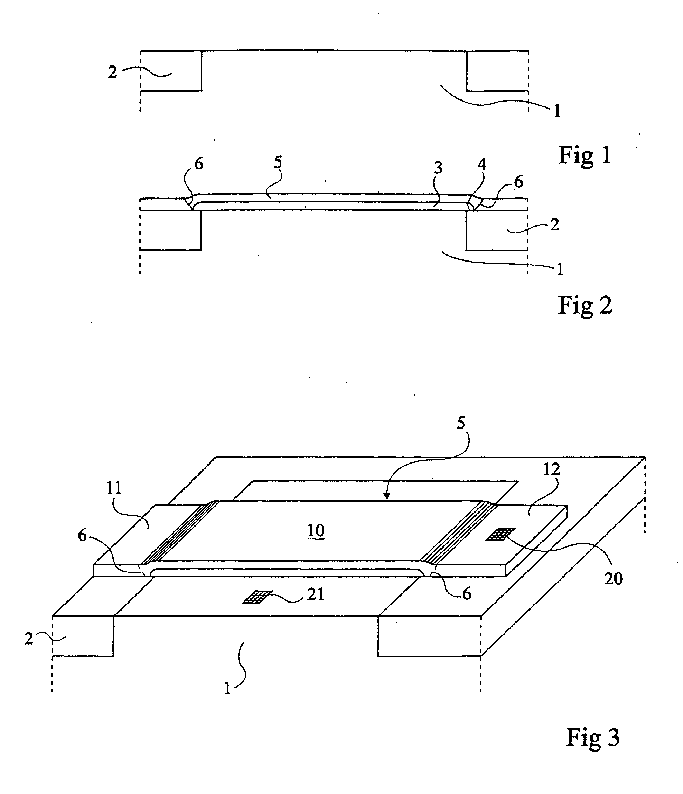

Comme le représente la figure 1, une structure selon la présente invention est constituée à partir d'une zone semiconductrice active 1 délimitée par une zone isolante 2 remplissant une tranchée formée à partir de la surface de la région 1.

La zone active 1 est éventuellement la partie supérieure d'un substrat semiconducteur ou peut correspondre à une couche mince semiconductrice formée sur un substrat isolant (SOI). Dans tous les cas, la région 1 sera de préférence fortement dopée et isolée d'un substrat sous-jacent par un isolement diélectrique ou par un isolement par jonction, comme cela est bien connu dans la technique. Les zones isolantes 2 sont par exemple en oxyde de silicium.

Comme l'illustre la figure 2, on amène à croître par épitaxie sélective une couche 3 de silicium-germanium au-dessus de la zone active 1. L'homme de l'art connaît divers procédés pour obtenir une telle épitaxie sélective qui ne sera pas décrite plus en détail. Lors de l'épitaxie, il se produit éventuellement un léger développement latéral de la couche épitaxiale, au-dessus de la périphérie interne 4 de la zone isolante 2. Ensuite, on fait croître uniformément une couche de silicium 5 (épitaxie non sélective). Cette couche de silicium se développera par épitaxie sous forme d'une couche de silicium monocristallin au-dessus de la couche de silicium-germanium 3 et sous forme de silicium polycristallin au-dessus de la couche isolante 2. La limite entre les régions de silicium monocristallin et polycristallin est indiquée schématiquement par la référence 6 en figure 2. On notera toutefois que cette limite est relativement fluctuante et dépend du procédé de fabrication.

Des étapes suivantes du procédé sont illustrées dans la vue en perspective schématique de la figure 3. Dans une première étape, on grave la couche de silicium 5 selon un contour choisi. Après cela, on procède à une gravure sélective de la couche de silicium-germanium 3. Cette gravure doit être sélective notamment par rapport au silicium 3 et 1, et être également sélective par rapport à l'oxyde de silicium 2. Pour cela, on choisira par exemple, un procédé de gravure chimique assisté par plasma, dans lequel le plasma sert à créer des molécules chimiques réactives tout près de la surface de la structure. Ce procédé met par exemple en oeuvre des molécules de NF₃, H₂ et N₂ ou de CF₄, H₂ et N₂. On pourra également procéder à une gravure chimique humide en présence de HNO₃ mélangé avec HF et H₂O₂ ou H₂O.

Ainsi, on obtient une poutre de silicium monocristallin 10 encastrée à ses deux extrémités 11 et 12 et séparée de façon extrêmement précise du substrat 1 d'une épaisseur qui correspond à la couche de SiGe 3 qui a été éliminée par gravure.

Après l'étape d'élimination par gravure de la couche de SiGe, on notera que le silicium apparent s'oxyde naturellement et se recouvre d'une couche très mince d'oxyde natif (épaisseur inférieure à 1 nm). On pourra également procéder à une oxydation thermique volontaire pour obtenir une couche d'oxyde d'une épaisseur de 1 à quelques nm.

On pourra également former des contacts 20 et 21, respectivement sur un pied 12 de la poutre 10 et sur la zone active 1 du substrat. D'autres moyens de contact avec la zone active 1 pourront être prévus.

La présente invention est susceptible de diverses variantes et modifications qui apparaîtront à l'homme de l'art. Ainsi, on a décrit précédemment la fabrication d'une poutre encastrée à ses deux extrémités, fonctionnant comme une corde vibrante. On pourra également prévoir une poutre encastrée à une seule de ses extrémités en procédant à une gravure par masquage de la couche mince de silicium monocristallin 5 pour éliminer l'encastrement 11 du côté gauche des figures 2 et 3.

A titre d'exemple d'ordre de grandeur, on pourra prévoir de former un résonateur tel que celui de la figure 3 dont la longueur est de l'ordre de 0,1 à 10 µm, dont la largeur est de l'ordre de 0,1 à quelques µm, dont l'épaisseur est de l'ordre de 5 à 100 nm, et dont la distance au substrat 1 est de l'ordre de 5 à 100 nm, toutes les couches de silicium monocristallin étant revêtues d'une couche d'oxyde mince d'une épaisseur de 1 à 5 nm.

Ainsi, la présente invention permet d'atteindre les objets visés. Du fait que la poutre encastrée est en silicium monocristallin, ses caractéristiques physiques sont parfaitement connues et donc notamment, son module de Young est bien défini et ses caractéristiques ne sont pas susceptibles de se dégrader au cours du temps. Par ailleurs, comme le montre bien l'exemple ci-dessus, on peut avec l'invention obtenir un dispositif particulièrement miniaturisé susceptible de fonctionner à de très hautes fréquences.

Dans le cas où la couche épitaxiale de SiGe 3 s'étend latéralement au-dessus de l'isolant 2, il n'y a pas de risque de court-circuit entre la zone active de silicium 1 et la couche de silicium 5 formée par épitaxie. Sinon, ce risque peut être éliminé par une légère attaque isotrope du silicium après gravure du silicium-germanium, et/ou par une oxydation thermique du silicium.

## Revendications

1. Résonateur électromécanique formé sur une zone active (1) de silicium monocristallin fortement dopée d'un substrat, constituant une première électrode délimitée par une zone isolante (2), comprenant une couche de silicium monocristallin reposant sur la zone isolante (2) par au moins une de ses extrémités et espacée de la zone active (1).

2. Procédé de fabrication d'un résonateur selon la revendication 1, **caractérisé en ce qu**'il comprend les étapes suivantes :
définir une zone active (1) de silicium monocristallin délimitée par une couche d'isolant enterré (2) ;
déposer une couche de silicium-germanium (3) par un procédé d'épitaxie sélective de sorte que la couche de silicium-germanium croisse au-dessus de la zone active de silicium monocristallin;
déposer par un procédé d'épitaxie non-sélective une couche de silicium (5) et la graver selon un contour désiré ; et
éliminer le silicium-germanium par une gravure sélective par rapport au silicium et à l'isolant.

3. Procédé selon la revendication 2, **caractérisé en ce qu**'il comprend en outre, après la gravure du silicium-germanium, une étape d'oxydation.

4. Procédé selon la revendication 2, **caractérisé en ce qu**'il comprend une étape de formation de contacts.

5. Procédé selon la revendication 2, **caractérisé en ce que** la gravure chimique sélective du silicium-germanium est assistée par plasma.

## Claims

1. An electromechanical resonator formed on an active heavily-doped single-crystal silicon area (1) of a substrate, forming a first electrode delimited by an insulating area (2), including a single-crystal silicon layer resting on the insulating area (2) by at least one of its ends and spaced apart from the active area (1).

2. A method for manufacturing the resonator of claim 1, **characterized in that** it includes the steps of:
defining an active single-crystal silicon area (1) delimited by a buried insulator layer (2);
depositing a silicon-germanium layer (3) by a selective epitaxy method so that the silicon-germanium layer grows above the active single-crystal silicon area and slightly beyond the periphery of this active area;
depositing by a non-selective epitaxy method a silicon layer (5) and etching it according to a desired contour; and
removing the silicon-germanium by a selective etching with respect to the silicon and to the insulator.

3. The method of claim 2, **characterized in that** it further includes, after the silicon-germanium etching, an oxidation step.

4. The method of claim 2, **characterized in that** it includes a contact forming step.

5. The method of claim 2, **characterized in that** the selective chemical etching of the silicon-germanium is plasma-aided.

## Patentansprüche

1. Ein elektromechanischer Resonator, der auf einem aktiven stark dotierten Einkristall-Siliziumbereich (1) eines Substrats ausgebildet ist, der eine erste Elektrode bildet, die durch einen isolierenden Bereich (2) begrenzt ist, umfasst eine Einkristall-Siliziumschicht, die auf den isolierenden Bereich (2) mit wenigstens einem ihrer Enden ruht, und von dem aktiven Bereich (1) beabstandet ist.

2. Verfahren zum Herstellen des Resonators nach Anspruch 1, **dadurch gekennzeichnet, dass** das Verfahren die folgenden Schritte aufweist:
Definieren eines aktiven Einkristall-Siliziumbereichs (1), der durch eine eingegrabene Isolierschicht (2) begrenzt ist;
Abscheiden einer Silizium-Germanium-Schicht (3) durch ein selektives Epitaxyverfahren, so dass die Silizium-Germanium-Schicht oberhalb des aktiven Einkristall-Siliziumbereichs aufwächst, und etwas uber den Umfang dieses aktiven Bereichs hinaus;
Abscheiden durch ein nicht selektives Epitaxyverfahren einer Siliziumschicht (5) und Ätzen derselben gemäß einer gewünschten Kontur; und
Entfernen der Silizium-Germanium-Schicht durch ein selektives Ätzen bezüglich des Siliziums und des Isolators.

3. Verfahren nach Anspruch 2 **dadurch gekennzeichnet, dass** es ferner einen Oxidationsschritt nach dem Silizium-Germanium-Ätzen aufweist.

4. Verfahren nach Anspruch 2 **dadurch gekennzeichnet, dass** es einen Kontaktausbildungsschritt umfasst.

5. Verfahren nach Anspruch 2 **dadurch gekennzeichnet, dass** das selektive chemische Ätzen der Silizium-Germanium-Schicht plasmaunterstützt ist.
